# EUROPEAN PATENT APPLICATION

(11) **EP 2 600 349 A1**
(43) Date of publication of application: **05.06.2013**
(21) Application number: 11191150.9
(22) Date of filing: 29.11.2011
(51) Int. Cl.: G11C 11/412

(54) **An ultra low power nine transistor static random access memory cell**

(71) Applicant: University College Cork, Cork City (IE)
(72) Inventor: Vasudevan, Dilip, Cork, Western Road (IE); Chen, Jiaoyan, Cork, Western Road (IE); Popovici, Emanuel, Cork, Western Road (IE); Shellekens, Michel, Cork, Western Road (IE)
(74) Representative: Purdylucey Intellectual Property

(57) **Abstract**

According to the invention there is provided a memory device comprising a storage means having three storage transistors adapted for storing information; writing means comprising two write transistors positioned to co-operate with said three storage transistors and adapted to write information to said storage transistors; and reading means comprising four transistors adapted to decouple the three storage transistors and adapted to provide a read function to read information from said storage means. The memory cell provides an improved power saving over existing memory devices.

## Description

### Field of the Invention

The invention relates to a memory cell or device. In particular the invention relates to a stable, ultra low power, static random access memory cell design.

### Background to the Invention

With the technology scaling reaching deep sub-nanometer and increasing density of the transistors in ICs the power consumption of the memory circuits is growing rapidly. Designing robust memory cell schemes which can consume lower power yet withholding good data read and write stability is currently challenging.

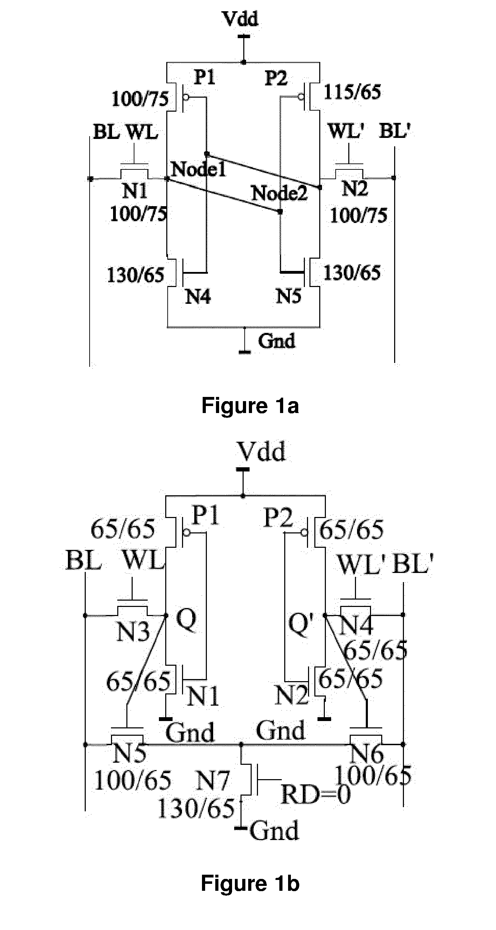

Static Random Access Memory (SRAM) is an inevitable component in designing the memory circuits/units of embedded systems, systems on chip, network on chip, 3D-IC, digital computing and communication systems, etc. A conventional 6T adiabatic SRAM cell and the 9T SRAM cell is disclosed in Z. Liu and V. Kursun, "Characterization of a novel nine-transistor SRAM cell," IEEE Trans. Very Large Scale Integr. Syst., vol. 16, no. 4, pp. 488-492, 2008, and shown in Fig. 1(a) and 1(b). A conventional 6T SRAM cell design is shown in Fig. 1(a). The standard cell was implemented in 65-nm CMOS technology. It was shown that data is most vulnerable to the external noise during the disturbance produced by the read operation. It was also shown that there are strict constraints on transistor sizing in order to maintain the data stability.

A more robust and low power design was proposed in Fig. 1 (b) compared to the conventional SRAM. Fig. 1(b) illustrates a 9T adiabatic SRAM cell. The design has the same feedback ring composed of two cross coupled inverters for the data storage as in the 6T SRAM. The transistors N3 and N4 are the write access transistors. The transistors N5, N6 and N7 are used for the write and read operations. The RD signal plays major role in both the read and write operation. It cut off the N7 during write operation by being set to low and activates N7 with a logic one.

Other solutions proposed include US 2008/0151605, assigned to ST Microelectronics; US 2010/0259973, assigned to Texas Instruments; US 7504695B2, assigned to Infineon Technologies; and US 2009/0290439, assigned to IBM. However a problem with these designs is that it results in poor leakage power and stability particularly for deep submicron technology nodes (where leakage has a significant impact). It is therefore desirable to provide a SRAM cell design with improved low leakage power and stable low power operation.

It is an object of the invention to provide a memory device to overcome at least one of the above mentioned problems.

### Summary of the Invention

According to the invention there is provided, as set out in the appended claims, a memory device comprising a storage means having three storage transistors adapted for storing information; writing means comprising two write transistors positioned to co-operate with said three storage transistors and adapted to write information to said storage transistors; and reading means comprising four transistors adapted to decouple the three storage transistors and adapted to provide a read function to read information from said storage means.

In one embodiment the invention provides a 9 transistor (9T) memory cell with the PMOS ring storing the information made up of 3 P-channel transistors. Two of the P-channel transistors are used to form a ring to store the data and each of them is connected between a power node and a storage node on either side of the storage cell. Read operation is facilitated by decoupling the storage nodes through the gates of two NMOS transistors. Two more N-channel transistors are connected between the bit lines and the decoupling transistors, with their gates connected to the read enable line.

The invention can be used to integrate with both the conventional high speed (non-adiabatic) processors and the low power adiabatic processor architectures. The invention can be used in any commercial products which demands ultra low power memories. Given the percentage of power contributed by the memories being very high in current digital systems, this invention provides low power system design when integrated with the microcontroller/microprocessor of the system or any embodiment which requires low power SRAM.

The main feature of the inventive design is that the power dissipation is significantly low comparable to the current state-of-the-art designs. The stability of the design is better compared to the conventional 6 transistor (6T) SRAM design. When the technology node is scaled down to 36nm, the conventional 6T design exhibits very low stability for the cell. The stability of the SRAM is defined as its ability to hold a binary logic 1 or 0 in the presence of noise to which these cells are exposed to. This design has the feature of being operated in adiabatic and non-adiabatic mode also. By operating in adiabatic mode, the power consumption can be further reduced at the cost of delay/speed performance. Overall all an ultra low power SRAM design is achieved with better stability to meet current low power demands.

The memory device of the present invention consumes very low power compared to the designs currently available. Significant reduction in the leakage power of the design during the idle/hold mode of operation of the SRAM is achieved. Most of the state-of-the-art cells use the conventional pair of crosscoupled inverters to hold the data. The disclosed design is implemented using P-channel transistors based ring.

In one embodiment the memory cell can be used in read intensive applications, very significant power savings can be further achieved compared to other SRAM choices as the read operation power consumption is order of magnitude lower than for other architectures.

In one embodiment the three storage transistors comprises three P-type transistors.

In one embodiment the two write transistors comprise two N-type transistors.

In one embodiment the four read transistors comprise four N-type transistors.

In one embodiment one storage transistor comprises means for sharing the voltage between two transistors to increase the stability of the device.

In one embodiment there is provided means to operate in an adiabatic mode.

In one embodiment there is provided means to operate non-adiabatic mode.

In one embodiment the storage means and/or writing means comprises no ground connection such that no leakage current losses occur.

In one embodiment the reading means comprises using a power supply.

In a further embodiment there is provided a SRAM device comprising
a storage means having three storage transistors adapted for storing information;
writing means comprising two write transistors positioned to co-operate with said three storage transistors and adapted to write information to said storage transistors; and
reading means comprising four transistors adapted to decouple the three storage transistors and adapted to provide a read function to read information from said storage means.

There is also provided a computer program comprising program instructions for causing a computer program to carry out the above method which may be embodied on a record medium, carrier signal or read-only memory.

### Brief Description of the Drawings

The invention will be more clearly understood from the following description of an embodiment thereof, given by way of example only, with reference to the accompanying drawings, in which:-
Figure 1 a & 1 b illustrate a prior art implementation of a memory cell;
Figure 2 illustrates an embodiment of the memory device according to the invention;
Figure 3 illustrates an analysis of results obtained showing operation of the memory cell device;
Figure 4 illustrates a comparison of Static Noise Margin (SNM) with the 6T and 9T designs;
Figure 5 illustrates a simulation waveform for all three steps of operation of the memory cell, including sharing, writing and reading waveform;
Figure 6 illustrates leakage current components of the proposed design during idle mode;
Figure 7 and 8 illustrates a plot of the average power consumption of the 6T, 9T (proposed), 8T and 9T memory cells (for 45nm and 65nm technology nodes respectively); and
Figure 9 illustrates results obtained for three 32X32 SRAM arrays comparing the energy used for write, read and share operations.

### Detailed Description of the Drawings

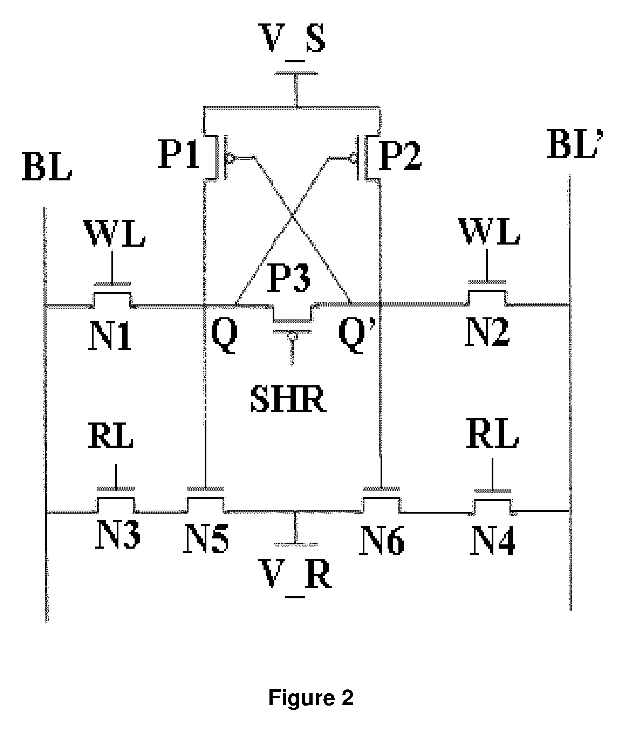

Referring now to the Figures, Figure 2 illustrates a memory cell according of a preferred embodiment of the invention. The memory cell shown in Figure 2 is adapted for adiabatic and non-adiabatic operation, the operation of which is discussed in more detail below.

Figure 2 illustrates a nine transistor (9T) adiabatic SRAM cell. The proposed SRAM cell is able to run in both adiabatic and non-adiabatic mode depending on the requirement of power and speed. Transistors N1, N2, P1, P2, P3 are used for writing operation and data retention. The writing access transistors (N1 and N2) are controlled by write signal WL. Two PMOS (P1 and P2) are combined to form a ring to store the data at node Q and Q'. The PMOS P3 controlled by SHR signal is placed between node Q and Q'. This transistor is designed to share the voltage between Q and Q' to meet the adiabatic principle. The four transistors below N3, N4, N5 and N6 take charge of read operation. N5 and N6 follow the control from Q and Q' respectively. N3 and N4 are controlled by a read line signal RL.

For Write Operation and in order to take advantage of adiabatic computing, a concept of "default value" is introduced in the design, whose value is chosen as VDD/2. Before WL goes high to overwrite nodes Q and Q', transistor P3 is turned on by signal SHR to share the voltage between these two nodes. In this way, Q and Q' will finally reach the same value VDD/2. During a write operation, in order to write '1' to node Q, first WL signal goes high, after that BL is charged from VDD/2 to VDD, and BL' is discharged from VDD/2 to 0. Once writing is finished, Q and Q' hold their new values '1' and '0' respectively. Signal WL goes down again to turn off the two write access transistors N1 and N2. Additionally, both BL and BL' have to be recovered to the default value after WL is set to zero. It should be noted that, power supply V S in the writing mode is set to 1 V, and changed to 0.8V in all other modes.

For the Read Operation in the read mode, node Q = with logic one and Q' = logic zero assumed, which means transistor N5 is on and N6 is off. When read signal RL goes high, it turns on the transistors N3 and N4. BL is then discharged by the power source V R through the path consisting of N3 and N5. Meanwhile, BL' stays at the default value. In non-adiabatic mode, the power source V R connected to the source of transistors N5 and N6 is set to ground level. After the data of BL and BL' is used by sense amplifier, V R is increased to VDD/2 again and along BL'. The read operation is completed and the transistors N3 and N4 can be switched off.

The memory cell of the invention provides an improved power saving. Dynamic power and static power are the two major components of power consumption. Dynamic power is dissipated when transistors switch. Leakage power is caused by the leakage current. Considering all the modes mentioned above, to take the advantage of adiabatic logic, the key strategy is never to turn on a transistor when there is a potential difference between source and drain. Furthermore, once the transistor is turned on, energy flows through it in a gradual and controlled manner. This so-called adiabatic computing greatly saves the dynamic power during charging and discharging. Even in non-adiabatic mode, since this SRAM works in half-swing mode, it also can save the power for both writing and reading. According to the structure of the SRAM cell in Fig. 2, there is no ground connection in the upper sub-circuit which means the leakage cannot flow into ground. Also the lower sub-circuit uses power supply V R to replace the normal ground connection. In adiabatic mode, except the read operation, V R is always set to VDD/2 which is exactly the same as the charge on BL and BL's capacitor in standby mode. All of these features reduce the leakage power dramatically.

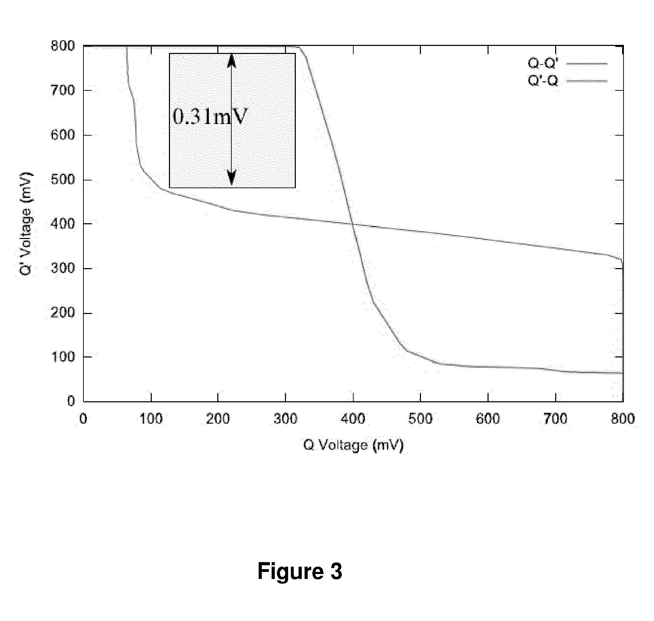

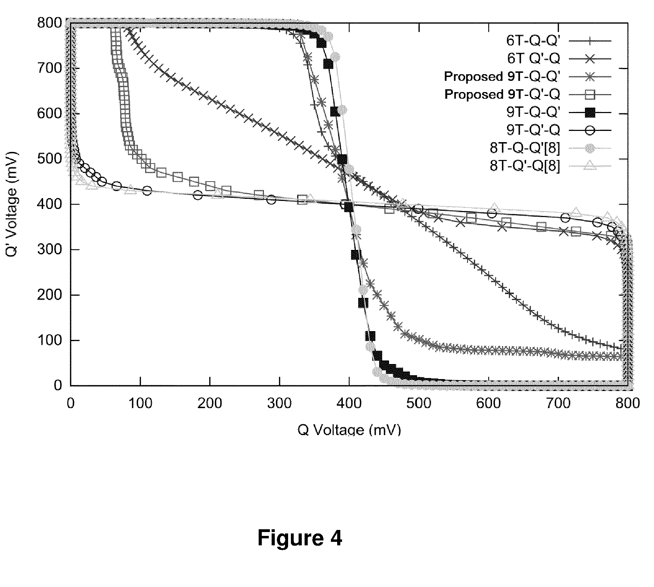

In order to illustrate operation of the invention it is necessary to compare with the performance with existing memory cell architectures. SNM (static noise margin) is the standard parameter to characterize the read stability of the SRAM cell. Since data storage node Q and Q' are completely isolated from the bit lines, the SNM is enhanced compared with the normal 6T SRAM cell. However, due to the following three factors 1) the power supply V S changed to 0.8V when writing is finished, 2) the absence of ground connection and 3) the presence of pull-down transistor in the memory cell, assuming node Q is at high voltage 0.8V; node Q' has its steady-state at 60mV which is worse than that in a conventional 9T SRAM cell shown in Fig. 1 b. The SNM graph for the proposed design is shown in Fig. 3. The voltage stability of 0.31 mV is obtained for the proposed design. The comparison of SNM with the 6T and 9T design is shown in Fig. 4.

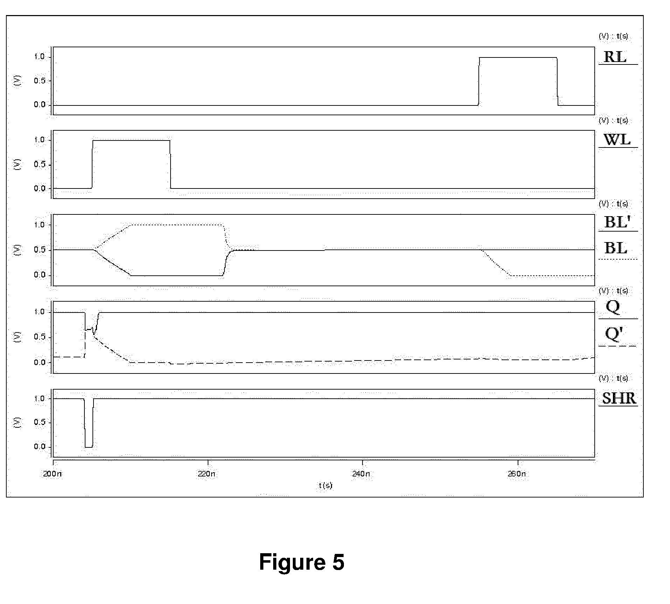

Figure 5 shows the simulation waveform for all three steps, including sharing, writing and reading. A step called sharing needs to be done before writing. The signal SHR(low) turns on the transistor P3 to share the energy between node Q and Q'. It is clear that voltage on node Q is down from 0.8V to 0.5, and node Q' is increased from 0V up to 0.5V which is essential for the SRAM to work adiabatically. Next step is to write the new data into the SRAM cell. As the two access transistors (N1 and N2 in Fig. 3) are switched on by signal WL, BL and BL' starts to charge and discharge respectively. Finally, BL reaches 1 V and BL' goes to 0V. Meanwhile, Q and Q' follow the value of BL and BL' respectively. It should be noticed that the node Q has changed to 0.8V after the writing is accomplished. This is because only 0.8V could make both node Q and Q' reach 0.5V after sharing. After this, the SRAM cell works in the standby mode waiting for reading or overwriting. Additionally, BL and BL' are recovered to the default voltage 0.5V after signal WL goes down. The last step is read operation. This operation includes two parts; reading and recovering. During the period between 97ns and 101 ns, according to the data in the SRAM cell, where Q is high and Q' is low, when read signal RL turns on transistors N3 and N4, BL is discharged by VR through N3 and N5, at the same time, BL' stays at half VDD. After the values of BL and BL' is used by the sense amplifier, V R forces the BL' (in this case) back to the default value 0.5V). Since the signal RL is raised back to low voltage again, the whole read operation is finished and the signal RL is back to zero to turn off transistors N3 and N4.

The comparison of the average power for the designs of the proposed 9T (both adiabatic and non-adiabatic), 6T and conventional 9T memory cells implemented in 45 and 65 nm technologies (libraries available commercially) are shown in the Table I.

**Table I Results: Average Power (* Libraries available commercially)**

| | Proposed 9T Adiabatic | Proposed 9T Non-Adiabatic | 6T | 9T |
|---|---|---|---|---|
| Lib-65nm*(nW) | | | | |
| Write | 43.1768 | 226.4817 | 442.723 | 427.3525 |
| Read | 4.5226 | 5.3465 | 547.9051 | 526.1101 |
| Sharing | 62.9298 | 62.9298 | - | - |
| Lib-45nm*(nW) | | | | |
| Write | 55.0234 | 215.7685 | 383.0343 | 375.3551 |
| Read | 3.8363 | 4.438 | 538.5062 | 513.1999 |
| Sharing | 38.5002 | 38.5002 | - | - |
| NCSU 45nm(nW) | | | | |
| Write | 58.9666 | 269.417 | 511.9575 | 465.3529 |
| Read | 5.3424 | 9.0247 | 605.9474 | 600.0872 |
| Sharing | 37.7983 | 37.7983 | - | - |

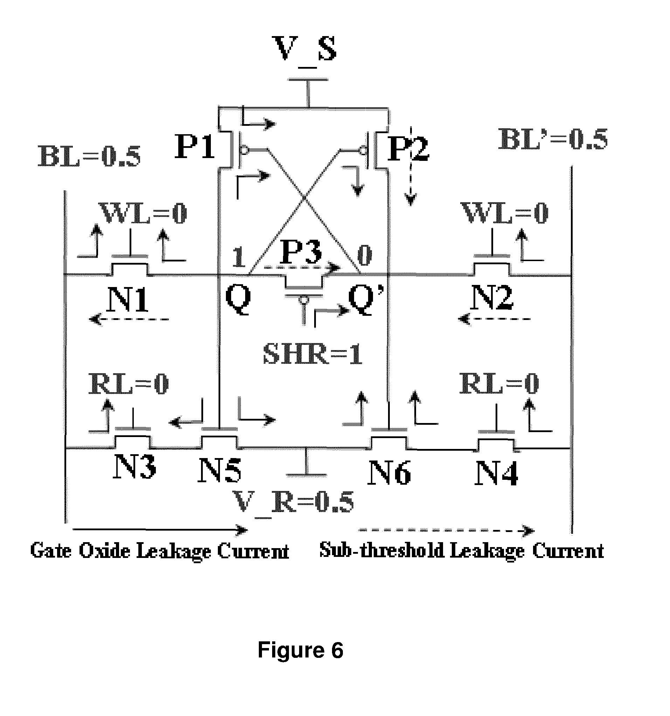

The leakage current components of the proposed design during idle mode is shown in Fig. 6. The idle mode leakage currents as shown in Fig. 6 contributes to the higher leakage. Channel Length, doping concentration, and gate-oxide thickness cause variations in the device characteristics. Hence the stability of the design with respect to process variation is investigated further. All the three designs were implemented in a commercially available 45nm process and Monte Carlo simulations using Synopsys's Hspice packages for 10000 samples with each SRAM in the idle mode were carried out. The fluctuations in the threshold voltage, doping concentration and gate oxide with normal distribution were assumed. The sigma variation of 10% was considered for each parameter.

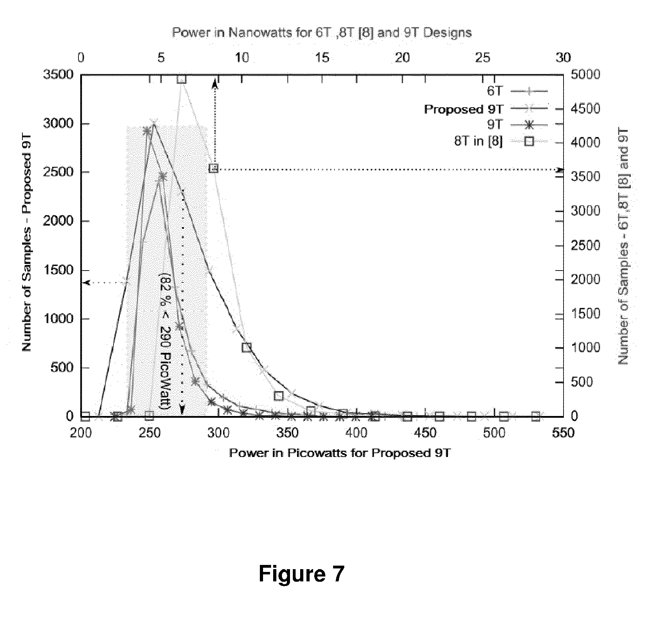

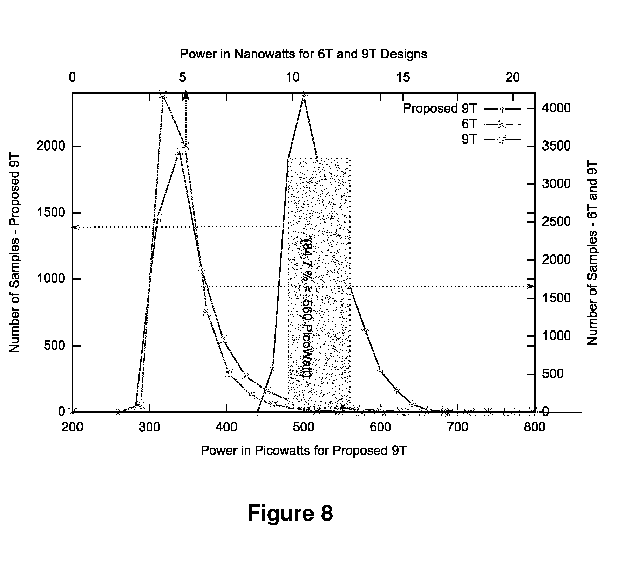

The Average Power consumption of the 6T, 9T (proposed), and prior art 8T and 9T memory cells is plotted and is shown in Fig. 7. The 8T cell used is similar to the one disclosed by L. Chang, R. Montoye, Y. Nakamura, K. Batson, R. Eickemeyer, R. Dennard, W. Haensch, and D. Jamsek, "An 8t-sram for variability tolerance and low-voltage operation in high-performance caches," Solid- State Circuits, IEEE Journal of, vol. 43, no. 4, pp. 956 -963, apr. 2008. The bottom x-axis gives the average power in picowatt for the proposed design while the top x-axis gives the average power in nanowatt. The results of the proposed design are shown as the line with "X" marking. Approximately 8200 samples (82%) had the average power lower than 290 pW. The conventional 9T design distribution had 7600 samples (76%) with the power between 4 and 6 nW. The conventional 6T design gave a distribution with the 7000 samples (70 %) between 3.85 and 6.85 nW. The 8T design in [8] had a distribution with 8562 samples 6 to 8nW. Also the Monte Carlo simulations for the three designs in 45 nm library are carried out. The results are shown in Fig. 8. The proposed design reported the average power lower than 560 picoWatt for 8200 (85 %) samples.

The 9T design distribution had 7600 samples (76 %) with the power between 4 and 6 nW. The conventional 6T design gave a distribution with the 7000 samples (70 %) between 3.85 and 6.85 nW.

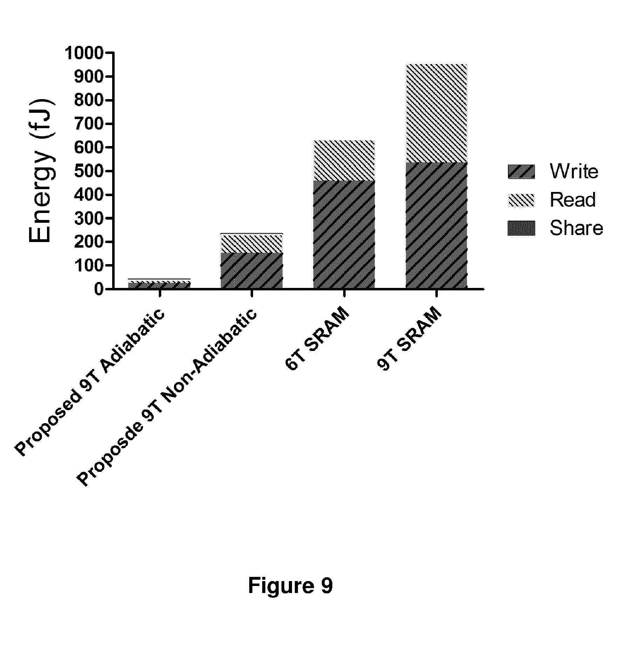

Figure 9 illustrates results obtained for three 32X32 SRAM arrays comparing the energy used for write, read and share operations. The three 32x32 SRAM array, which were built by the standard 6T, the 9T and the proposed 9T cell, were implemented at 45nm technology running at 100MHz. Both adiabatic mode and non-adiabatic mode were run on our 32x32 SRAM array. Figure 9 illustrates power comparison among the three types of design. When the SRAM array of the present invention was run in adiabatic mode, the energy consumed during writing operation is 25.8fJ. While in non-adiabatic mode, about 152fJ is cost. It is almost 6 times higher than that in adiabatic mode. The writing power for the 6T SRAM array is 458fJ. The reduction of the design of the present invention is about 94% and 67% in adiabatic mode and non-adiabatic mode respectively. Furthermore, the 9T SRAM array consumes 535fJ energy, which is the highest among all three designs. The results for reading operation are very similar to the writing. The design costs only 12.8fJ and 77.8fJ for adiabatic and non-adiabatic reading. The power for 6T one is 174fJ while it is 422fJ for 9T style. Although there is about 5fJ is dissipated during the sharing. It is clearly shown that the invention provides ultra low power property compared to the conventional 6T and the 9T memory cell.

It will be appreciated that the invention provides a new SRAM memory cell design. The power consumption of the cell is on the order of 10 times (90 - 91 %) lower than the conventional 6T SRAM prior art cells and the memory cells. The adiabatic operation of the cell further reduces the power consumption with a trade off in the performance/delay. The proposed cell is suitable for the applications requiring ultra low power consumption. Currently the design is investigated at 36 nm process, where 6T SRAM design is completely unstable, but the proposed design is giving a substantial stability.

The embodiments in the invention described with reference to the drawings comprise a computer apparatus and/or processes performed in a computer apparatus. However, the invention also extends to computer programs, particularly computer programs stored on or in a carrier adapted to bring the invention into practice. The program may be in the form of source code, object code, or a code intermediate source and object code, such as in partially compiled form or in any other form suitable for use in the implementation of the method according to the invention. The carrier may comprise a storage medium such as ROM, e.g. CD ROM, or magnetic recording medium, e.g. a floppy disk or hard disk. The carrier may be an electrical or optical signal which may be transmitted via an electrical or an optical cable or by radio or other means.

In the specification the terms "comprise, comprises, comprised and comprising" or any variation thereof and the terms include, includes, included and including" or any variation thereof are considered to be totally interchangeable and they should all be afforded the widest possible interpretation and vice versa.

The invention is not limited to the embodiments hereinbefore described but may be varied in both construction and detail.

## Claims

1. A memory device comprising:
a storage means having three storage transistors adapted for storing information;
writing means comprising two write transistors positioned to co-operate with said three storage transistors and adapted to write information to said storage transistors; and
reading means comprising four read transistors adapted to decouple the three storage transistors and adapted to provide a read function to read information from said storage means.

2. The memory device of claim 1 wherein the three storage transistors comprises three P-type transistors.

3. The memory device of claims 1 or 2 wherein the two write transistors comprises two N-type transistors.

4. The memory device of any preceding claim wherein the four read transistors comprises four N-type transistors.

5. The memory device of any preceding claim wherein the storage means comprises a three P-type transistor based ring.

6. The memory device of any preceding claim wherein one storage transistor comprises means for sharing the voltage between two transistors to increase the stability of the device and reduce the power.

7. The memory device of any preceding claim comprising means to operate in an adiabatic mode.

8. The memory device of any preceding claim comprising means to operate non-adiabatic mode.

9. The memory device of any preceding claim wherein the storage means and/or writing means comprises no ground connection such that no leakage current losses occur.

10. The memory device of claim 8 wherein the reading means comprises using a power supply.

11. A SRAM device comprising the memory device of any of claims 1 to 10.
